# EUROPEAN PATENT APPLICATION

(11) **EP 2 688 101 A1**
(43) Date of publication of application: **22.01.2014**
(21) Application number: 12177216.4
(22) Date of filing: 20.07.2012
(51) Int. Cl.: H01L 25/07

(54) **Method for electrically connecting vertically positioned substrates**

(71) Applicant: ABB Technology AG, 8050 Zürich (CH)
(72) Inventor: Pâques, Gontran, 5702 Niederlenz (CH); Trüssel, Dominik, 5620 Bremgarten (CH); Groot, Waldemar, 5600 Lenzburg (CH); Ellenbroek, Stefan, 8302 Kloten (CH); Hajas, David, 5102 Rupperswil (CH)
(74) Representative: ABB Patent Attorneys

(57) **Abstract**

The present invention provides a method for electrically connecting a contact (7) of a first substrate (3) to a contact (11) of a second substrate (5), whereby the first substrate (3) is positioned below the second substrate (5), comprising the steps of providing the first substrate (3) with its contact (7) facing towards the second substrate (5), providing the second substrate (5) with its contact (11) facing away from the first substrate (3), bonding a bonding means (15) to the contact (7) of the first substrate (3), bonding the bonding means (15) to the first substrate (3) thereby forming a loop (17), and electrically connecting the contact (11) of the second substrate (5) to the bonding means (15). The present invention also provides an arrangement (1) of a first and a second substrate (3, 5), whereby the first substrate (3) is positioned below the second substrate (5), wherein a contact (7) of the first substrate (3) is connected to a contact (11) of the second substrate (5) according to the above method and a power semiconductor module comprising the above arrangement (1).

## Description

### Technical Field

The present invention relates to the area of electrically connecting a contact of a first substrate to a contact of a second substrate, whereby the first substrate is positioned below the second substrate.

### Background Art

Arrangements of two substrates in a vertical direction are for example used in power semiconductor modules. Power semiconductor modules are used in high power applications to switch high voltages and currents and comprise multiple power semiconductors. Since each single semiconductor has a maximum voltage and current, the power semiconductors are frequently combined in parallel and/or in series within the power semiconductor modules to enable the use in high power applications. To facilitate the manufacturing of such modules they commonly comprise multiple first substrates, on which the power semiconductors are mounted. These substrates are provided with contacts for emitter, collector and base, so that the first substrates can easily be connected within the power semiconductor modules.

The first substrates are typically mounted on a common base plate, which can be part of a housing of the power semiconductor module or which can be held within a housing of the power semiconductor module. In nowadays power semiconductor modules, typically four or six first substrates are combined, each provided with four to six power semiconductors comprising power transistors like insulated gate bipolar transistors (IGBT) or reverse conducting insulated gate bipolar transistors (RC-IGBT), power diodes, or other power semiconductors suitable for high power applications. For example, a first substrate can comprise four IGBTs and two power diodes. The first substrates are electrically connected to terminals, which provide a connection of the metallizations within the power semiconductor module. E.g. the electric terminals can be connected to electric contacts of the power semiconductor module.

The power semiconductor module further comprises a second substrate, which provides an auxiliary connection for electrically connecting terminals corresponding to auxiliary metallizations to the electric contacts of the power semiconductor module. Accordingly, a power semiconductor module comprises an arrangement of a first and a second substrate, which are positioned above each other. To provide an electric connection from the first substrate to the second substrate, in known power semiconductors modules a connection element is provided. The connection element, e.g. an auxiliary pin, is first soldered to the respective terminal of the first substrate, and then the second substrate is soldered onto the connection element. In case multiple first substrates are connected to one second substrate, the second substrate is commonly soldered to auxiliary pins of the first substrates. This method for connecting the two substrates is complicated and time consuming. Furthermore, since the power semiconductor modules underlie thermo-mechanical stress, a reliable electric connection between the two substrates is required.

### Disclosure of Invention

It is an object of the present invention to provide a method for electrically connecting a contact of a first substrate to a contact of a second substrate, which allows easily and rapidly providing a reliable electric connection between contacts of the first and second substrates with an increased resistance to mechanical and thermal influences. It is a further object of the present invention to provide an arrangement of a first and a second substrate and a power semiconductor module comprising such an arrangement, which are easy to manufacture and which are provided with a reliable electric connection between contacts of the first and second substrates with an increased resistance to mechanical and thermal influences.

This object is achieved by the independent claims. Advantageous embodiments are given in the dependent claims.

In particular, the present invention provides a method for electrically connecting a contact of a first substrate to a contact of a second substrate, whereby the first substrate is positioned below the second substrate, comprising the steps of providing the first substrate with its contact facing towards the second substrate, providing the second substrate with its contact facing away from the first substrate, bonding a bonding means to the contact of the first substrate, bonding the bonding means to the first substrate thereby forming a loop, and electrically connecting the contact of the second substrate to the bonding means.

The present invention further provides an arrangement of a first and a second substrate, whereby the first substrate is positioned below the second substrate, wherein a contact of the first substrate is connected to a contact of the second substrate according to the above method.

The present invention also provides a power semiconductor module comprising such an arrangement.

The basic idea of the invention is to use a bonding means for connecting the contacts of the two substrates. The bonding means, which can be a bonding wire or a bonding ribbon, passes on top of the second substrate and can be easily connected to the substrates in a known way, so that the manufacturing process can be easily performed. The connection of the bonding means can be made to the contacts of both substrates can be made from the same direction, which facilitates the production of the arrangement of the two substrates and the power semiconductor module. With the loop formed in the bonding means, the connection of the two substrates is flexible, so that a relative movement of the two substrates is enabled. Accordingly, thermo-mechanical stress resistance of the arrangement of the two substrates and the power semiconductor module can be improved. Also shocks and vibrations can be decoupled between the two substrates. Further preferred, the bonding means is cut after bonding to the first substrate. Accordingly, the length of the bonding means on the first substrate can be adapted during the bonding process. Bonding can be easily performed by use of common bonding equipment. The step of bonding the bonding means to the first substrate thereby forming a loop can comprise bonding the bonding means to any suitable place on the first substrate. E.g. an isolated metallization, i.e. an island, can be provided on the first substrate merely for the purpose of connection of the bonding means to enable the loop configuration thereof. Bonding can be performed using any known bonding technique.

Although the method steps are listed in a particular order, this does not imply any order in which the method steps have to be performed. The steps can be performed in different orders, as further detailed below. E.g. the steps of bonding a bonding means to the contact of the first substrate and bonding the bonding means to the first substrate thereby forming a loop can be substituted, so that the loop can be formed when the bonding means is bonded to the contact of the first substrate.

According to a modified embodiment of the invention the steps of bonding a bonding means to the contact of the first substrate and bonding the bonding means to the first substrate thereby forming a loop are executed prior to the step of connecting the contact of the second substrate to the bonding means, and the method comprises prior to the step of connecting the contact of the second substrate to the bonding means the additional step of inserting the second substrate through the loop. In other words, the bonding means is first bonded to the first substrate, so that the loop is formed and connected thereto, and then the second substrate is at least partially inserted into the loop so that the loop passes over the contact of the second substrate for electrically connecting it thereto in a subsequent step. Accordingly, the bonding means can be guided above the second substrate to the contact of the second substrate. With the loop formed prior to the connection of the bonding means to the contact of the second substrate, bonding of the bonding means can be easily performed. Still, it does not matter which end of the loop is bonded first to the first substrate.

According to a modified embodiment of the invention the step of electrically connecting the contact of the second substrate to the bonding means is performed prior to the step of bonding the bonding means to the first substrate thereby forming a loop, and the step of electrically connecting the contact of the second substrate to the bonding means comprises bonding the bonding means to the contact of the second substrate. In other words, a continuous bonding process is performed for electrically connecting the contacts of the two substrates. First, the bonding means is bonded to the first substrate, then the bonding means is bonded to the contact of the second substrate, and the loop is completed by bonding the bonding means to the first substrate. Preferably, the bonding means is additionally fixed to the contact of the second substrate after being bonded thereto to increase the strength of the connection. Still, it does not matter which end of the loop is bonded first to the first substrate.

A modified embodiment of the invention comprises the additional step of providing the second substrate with a nose extending from an edge of the second substrate, whereby the contact of the second substrate is provided on the nose. The nose of the second substrate facilitates the placement of the bonding means and its connection to the substrates. The nose can be easily inserted into the loop. Furthermore, the nose allows simple access to the first substrate for bonding the bonding means thereto, when the first substrate is already positioned below the second substrate. The nose is preferably located in the plane of the second substrate.

A modified embodiment of the invention comprises the additional step of providing the second substrate with two notches forming a tongue there between, whereby the contact of the second substrate is provided on the tongue. The tongue of the second substrate facilitates the placement of the bonding means and its connection to the substrates. The tongue can be easily inserted into the loop by inserting the bonding means into the notches. The bonding means can be positioned in the notches so that is it supported in its position during the connection process. The tongue is preferably located in the plane of the second substrate. Further preferred, the tongue is provided within the circumference of the second substrate.

A modified embodiment of the invention comprises the additional step of providing the nose or the tongue with a smaller extension at its end connected to the second substrate compared to the extension of its free end, and the step of inserting the second substrate through the loop comprises passing the bonding means over the end of the nose or tongue with the greater extension. When the bonding means is passed over the end with the greater extension, it is automatically secured on the nose or tongue, which further facilitates the manufacturing process. Unintended movements of the two substrates relative to each other during the manufacturing process do not automatically require a repeated positioning of the bonding means over the contact of the second substrate.

According to a modified embodiment of the invention the step of providing the nose or the tongue with a smaller extension at its end connected to the second substrate compared to the extension of its free end comprises providing the nose or the tongue with a T-shape or an anchor-shape. These shapes can be easily formed and allow simple insertion of the nose or tongue into the loop, whereas unintended removal of the nose or tongue through the loop is avoided due to the chosen shape.

According to a modified embodiment of the invention the step of electrically connecting the contact of the second substrate to the bonding means comprises gluing, bonding, welding, soldering or brazing. These steps can be performed to provide a mechanical and electrical connection between the bonding means and the contact of the second substrate. Also, different connection steps can be combined. In particular, the bonding means can first be bonded to the contact, and then the connection can be strengthened by applying an additional connection step, e.g. soldering or welding. The same connection techniques can be applied to the connection of the bonding means to the first substrate in addition the bonding steps.

According to a modified embodiment of the invention the step of bonding the bonding means to the first substrate thereby forming a loop comprises bonding the bonding means to the contact of the first substrate. In other words, the bonding means is bonded twice to the same contact of the first substrate, so that a redundant electric path is established between the contacts of the two substrates. In case of failure of one path, i.e. the bonding means is cut for any reason, the remaining path can provide the electrical connection between the two contacts. Preferably, the contact of the first substrate has a size bigger than the contact of the second substrate, so that the loop can be easily formed.

A modified embodiment of the invention comprises the step of providing the bonding means made of copper. Copper is a suitable material for bonding since it can generally be bonded to different materials. Nevertheless, also other materials, e.g. aluminum, can be used for the bonding means.

A modified embodiment of the invention comprises the step of providing the contacts of the first and second substrate and the bonding means made of the same material. The connection between the contacts and the bonding means can be easily formed and have a high robustness when the same material is used. Further preferred, also the island on the first substrate, if present, is made of the same material.

A modified embodiment of the invention comprises the step of providing a as bonding means a thin bonding wire having a diameter of 400 µm or less. The thin bonding wire facilitates forming the loop in the bonding process.

According to a modified embodiment of the invention contacts of multiple first substrates are connected to contacts of one second substrate.

According to a modified embodiment of the invention power semiconductors are mounted on the first substrate and the second substrate is provided as an auxiliary connection for providing an auxiliary contact of the power semiconductor module.

### Brief Description of Drawings

These and other aspects of the invention will be apparent from and elucidated with reference to the embodiments described hereinafter.

In the drawings:

Fig. 1 shows an arrangement of two substrates with contacts connected by a bonding wire according to a first embodiment, and

Fig. 2 shows an arrangement of two substrates with contacts connected by a bonding wire according to a second embodiment.

### Detailed Description of the Invention

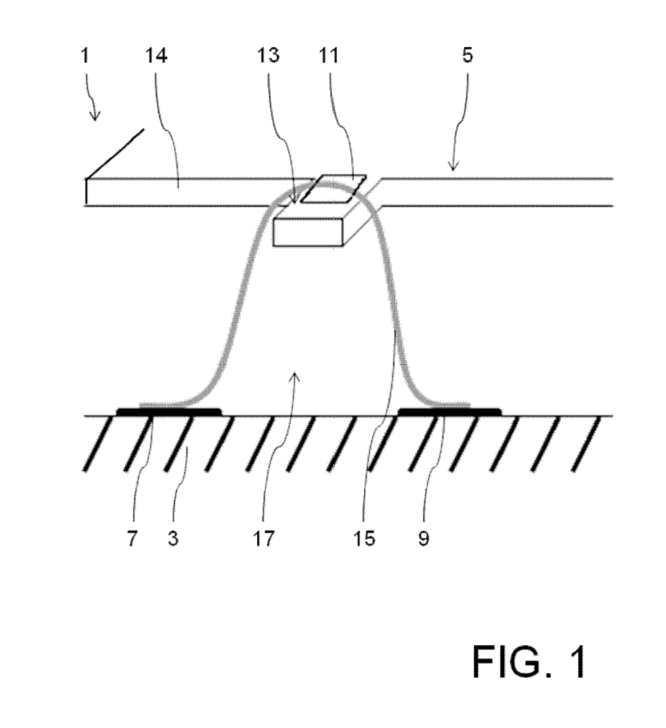

Fig. 1 shows an arrangement 1 of a first and a second substrate 3, 5 according to a first embodiment. The first substrate 3 is positioned below the second substrate 5, and the arrangement 1 is made for use in a power semiconductor module. Accordingly, power semiconductors are mounted on the first substrate 3 and the second substrate 5 is provided as an auxiliary connection for providing an auxiliary contact of the power semiconductor module.

The first substrate 3 has a two metallizations 7, 9, from which one metallization 7 refers to a contact 7 of the first substrate 3. The second metallization 9 is provided as an island on the first substrate 3 without electrical function.

As can be seen in Fig. 1, the second substrate 5 has one contact 11, which is positioned on a nose 13 extending from an edge 14 of the second substrate 5. Accordingly, the contact 7 of the first substrate 3 faces towards the second substrate 5, and the contact 11 of the second substrate 5 faces away from the first substrate 3.

The contact 7 of the first substrate 3, the island 9, and the contact 11 of the second substrate 5 are connected by bonding means 15, which is a bonding wire 15 in this embodiment. The bonding wire 15 in this embodiment has a diameter of 375 µm. The contacts 7, 11 of the first and second substrate 3, 5, the island 9, and the bonding wire 15 are made of the same material, which is copper in this embodiment.

A method for electrically connecting the contacts 7, 11 of the two substrates 3, 5 according to the first embodiment will now be described.

Initially, the first substrate 3 and the second substrate 5 are provided, whereby the contact 7 and the island 9 of the first substrate 3 face towards the second substrate 5 and the contact 11 of the second substrate 5 faces away from the first substrate 3.

Subsequently, the bonding wire 15 is bonded to the contact 7 of the first substrate 3. Next, the bonding wire 15 is electrically connected to the contact 11 of the second substrate 5 by means of bonding. In a subsequent step, a loop 17 is formed in the bonding wire 15 by bonding the bonding wire 15 to the island 9 of the first substrate 3. After bonding the bonding wire 15 to the island 9 of the first substrate 3, the bonding wire 15 is cut off so that a bonding tool used for bonding the bonding wire 15 can be used bonding further bonding wires 15.

The connection of the contact 11 of the second substrate 5 to the bonding wire 15 is then reinforced by an additional soldering step applied to this connection.

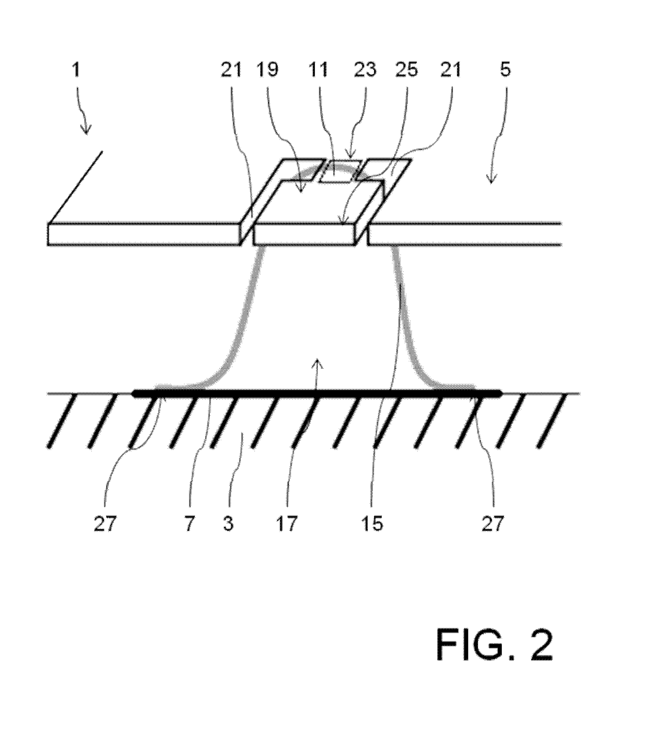

Fig. 2 shows an arrangement 1 of a first and a second substrate 3, 5 according to a second embodiment. The arrangement 1 of the second embodiment is similar to the arrangement 1 of the first embodiment, so that it is described using the same reference numerals for similar components.

The first substrate 3 is positioned below the second substrate 5, and the arrangement 1 is made for use in a power semiconductor module. Accordingly, power semiconductors are mounted on the first substrate 3 and the second substrate 5 is provided as an auxiliary connection for providing an auxiliary contact of the power semiconductor module.

The first substrate 3 has one metallization 7, which refers to a contact 7 of the first substrate 3. As can be seen in Fig. 1, the second substrate 5 has one contact 11, which is positioned on a tongue 19 of the second substrate 5. The tongue 19 is formed between two notches 21 within a circumference of the second substrate 5. The tongue 19 is provided with a T-shape, so that it has a smaller extension at its end 23 connected to the second substrate 5 compared to the extension of its free end 25.

As can be seen in Fig. 2, the contact 7 of the first substrate 3 faces towards the second substrate 5, and the contact 11 of the second substrate 5 faces away from the first substrate 3.

A bonding means 15, which is a bonding wire 15 in this embodiment, is connected at its ends 27 to the contact 7 of the first substrate 3, thereby forming a loop 17. Additionally, the bonding wire 15 is connected to the contact 11 of the second substrate 5. The bonding wire 15 in this embodiment has a diameter of 375 µm. The contacts 7, 11 of the first and second substrate 3, 5 and the bonding wire 15 are made of the same material, which is copper in this embodiment.

A method for electrically connecting the contacts 7, 11 of the two substrates 3, 5 according to the second embodiment will now be described.

Initially, the first substrate 3 and the second substrate 5 are provided, whereby the contact 7 of the first substrate 3 faces towards the second substrate 5 and the contact 11 of the second substrate 5 faces away from the first substrate 3.

Subsequently, the bonding wire 15 is bonded to the contact 7 of the first substrate 3 and the loop 17 is formed in the bonding wire 15 by bonding the bonding wire 15 again to the contact 7 of the first substrate 3. Subsequently, the bonding wire 15 is cut off so that a bonding tool can be used bonding further bonding wires 15.

In a following step, the tongue 19 of the second substrate 5 is inserting through the loop 17 so that the bonding wire 15 is guided above the contact 11 of the second substrate 5. Accordingly, the bonding wire 15 is passed over the free end 25 of the tongue 19 and the bonding wire 15 is positioned above the contact 11, which is located in a different area of the tongue 19 at its end 23 connected to the second substrate 5.

Next, the bonding wire 15 is electrically connected to the contact 11 of the second substrate 5 by means of soldering or a different connection step.

While the invention has been illustrated and described in detail in the drawings and foregoing description, such illustration and description are to be considered illustrative or exemplary and not restrictive; the invention is not limited to the disclosed embodiments. Other variations to be disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

- 1: arrangement
- 3: first substrate
- 5: second substrate
- 7: first metallization, contact of first substrate
- 9: second metallization, island
- 11: contact of second substrate
- 13: nose
- 14: edge of second substrate
- 15: bonding means, bonding wire
- 17: loop
- 19: tongue
- 21: notch
- 23: end of tongue connected to the second substrate
- 25: free end of tongue
- 27: end of bonding wire

## Claims

1. Method for electrically connecting a contact (7) of a first substrate (3) to a contact (11) of a second substrate (5), whereby the first substrate (3) is positioned below the second substrate (5), comprising the steps of
providing the first substrate (3) with its contact (7) facing towards the second substrate (5),
providing the second substrate (5) with its contact (11) facing away from the first substrate (3),
bonding a bonding means (15) to the contact (7) of the first substrate (3), bonding the bonding means (15) to the first substrate (3) thereby forming a loop (17), and
electrically connecting the contact (11) of the second substrate (5) to the bonding means (15).

2. Method according to claim 1, wherein
the steps of bonding a bonding means (15) to the contact (7) of the first substrate (3) and bonding the bonding means (15) to the first substrate (3) thereby forming a loop (17) are executed prior to the step of connecting the contact (11) of the second substrate (5) to the bonding means (15), and
the method comprises prior to the step of connecting the contact (11) of the second substrate (5) to the bonding means (15) the additional step of
inserting the second substrate (5) through the loop (17).

3. Method according to claim 1, wherein
the step of electrically connecting the contact (11) of the second substrate (5) to the bonding means (15) is performed prior to the step of bonding the bonding means (15) to the first substrate (3) thereby forming a loop (17), and
the step of electrically connecting the contact (11) of the second substrate (5) to the bonding means (15) comprises bonding the bonding means (15) to the contact (11) of the second substrate (5).

4. Method according to any of preceding claim, comprising the additional step of
providing the second substrate (5) with a nose (13) extending from an edge (14) of the second substrate (14), whereby the contact (11) of the second substrate (5) is provided on the nose (13).

5. Method according to any of preceding claim, comprising the additional step of
providing the second substrate (5) with two notches (21) forming a tongue (19) there between, whereby the contact (11) of the second substrate (5) is provided on the tongue (19).

6. Method according to any of preceding claims 4 or 5 in combination with claim 2, comprising the additional step of
providing the nose (13) or the tongue (19) with a smaller extension at its end (23) connected to the second substrate (5) compared to the extension of its free end (25), and
the step of inserting the second substrate (5) through the loop (17) comprises passing the bonding means (15) over the end (25) of the nose (13) or tongue (19) with the greater extension and positioning the bonding means (15) in a different area of the nose (13) or tongue (19).

7. Method according to claim 6, wherein
the step of providing the nose (13) or the tongue (19) with a smaller extension at its end (23) connected to the second substrate (5) compared to the extension of its free end (25) comprises providing the nose (13) or the tongue (19) with a T-shape or an anchor-shape.

8. Method according to any of preceding claim, wherein
the step of electrically connecting the contact (11) of the second substrate (5) to the bonding means (15) comprises gluing, bonding, welding, soldering or brazing.

9. Method according to any preceding claim, wherein
the step of bonding the bonding means (15) to the first substrate (3) thereby forming a loop (17) comprises bonding the bonding means (15) to the contact (7) of the first substrate (3).

10. Method according to any preceding claim,
comprising the step of providing the bonding means (15) made of copper.

11. Method according to any preceding claim,
comprising the step of providing the contacts (7, 9) of the first and second substrate (3, 5) and the bonding means (15) made of the same material.

12. Arrangement (1) of a first and a second substrate (3, 5), whereby the first substrate (3) is positioned below the second substrate (5), wherein
a contact (7) of the first substrate (3) is connected to a contact (11) of the second substrate (5) according to the method of any preceding claim.

13. Arrangement according to preceding claim 12, wherein
contacts (7) of multiple first substrates (3) are connected to contacts (11) of one second substrate (5).

14. Power semiconductor module comprising an arrangement (1) according to any of claims 12 or 13.

15. Power semiconductor module according to preceding claim 14, wherein
power semiconductors are mounted on the first substrate (3) and the second substrate (5) is provided as an auxiliary connection for providing an auxiliary contact of the power semiconductor module.

## Amended claims

### Amended claims in accordance with Rule 137(2) EPC.

**1.** Method for electrically connecting a contact (7) of a first substrate (3) to a contact (11) of a second substrate (5), whereby the first substrate (3) is positioned below the second substrate (5), comprising the steps of
providing the first substrate (3) with its contact (7) facing towards the second substrate (5),
providing the second substrate (5) with its contact (11) facing away from the first substrate (3),
bonding a bonding means (15) to the contact (7) of the first substrate (3), bonding the bonding means (15) to the first substrate (3) thereby forming a loop (17),
electrically connecting the contact (11) of the second substrate (5) to the bonding means (15), and
providing the second substrate (5) with a nose (13) extending from an edge (14) of the second substrate (14), whereby the contact (11) of the second substrate (5) is provided on the nose (13).

**2.** Method according to claim 1, wherein
the steps of bonding a bonding means (15) to the contact (7) of the first substrate (3) and bonding the bonding means (15) to the first substrate (3) thereby forming a loop (17) are executed prior to the step of connecting the contact (11) of the second substrate (5) to the bonding means (15), and
the method comprises prior to the step of connecting the contact (11) of the second substrate (5) to the bonding means (15) the additional step of
inserting the second substrate (5) through the loop (17).

**3.** Method according to claim 1, wherein
the step of electrically connecting the contact (11) of the second substrate (5) to the bonding means (15) is performed prior to the step of bonding the bonding means (15) to the first substrate (3) thereby forming a loop (17), and
the step of electrically connecting the contact (11) of the second substrate (5) to the bonding means (15) comprises bonding the bonding means (15) to the contact (11) of the second substrate (5).

**4.** Method according to any of preceding claim, comprising the additional step of providing the second substrate (5) with two notches (21) forming a tongue (19) there between, whereby the contact (11) of the second substrate (5) is provided on the tongue (19).

**5.** Method according to any of preceding claims 1 or 4 in combination with claim 2, comprising the additional step of
providing the nose (13) or the tongue (19) with a smaller extension at its end (23) connected to the second substrate (5) compared to the extension of its free end (25), and
the step of inserting the second substrate (5) through the loop (17) comprises passing the bonding means (15) over the end (25) of the nose (13) or tongue (19) with the greater extension and positioning the bonding means (15) in a different area of the nose (13) or tongue (19).

**6.** Method according to claim 5, wherein
the step of providing the nose (13) or the tongue (19) with a smaller extension at its end (23) connected to the second substrate (5) compared to the extension of its free end (25) comprises providing the nose (13) or the tongue (19) with a T-shape or an anchor-shape.

**7.** Method according to any of preceding claim, wherein
the step of electrically connecting the contact (11) of the second substrate (5) to the bonding means (15) comprises gluing, bonding, welding, soldering or brazing.

**8.** Method according to any preceding claim, wherein
the step of bonding the bonding means (15) to the first substrate (3) thereby forming a loop (17) comprises bonding the bonding means (15) to the contact (7) of the first substrate (3).

**9.** Method according to any preceding claim,
comprising the step of providing the bonding means (15) made of copper.

**10.** Method according to any preceding claim,
comprising the step of providing the contacts (7, 9) of the first and second substrate (3, 5) and the bonding means (15) made of the same material.

**11.** Arrangement (1) of a first and a second substrate (3, 5), whereby the first substrate (3) is positioned below the second substrate (5), wherein
a contact (7) of the first substrate (3) is connected to a contact (11) of the second substrate (5) according to the method of any preceding claim.

**12.** Arrangement according to preceding claim 11, wherein
contacts (7) of multiple first substrates (3) are connected to contacts (11) of one second substrate (5).

**13.** Power semiconductor module comprising an arrangement (1) according to any of claims 11 or 12.

**14.** Power semiconductor module according to preceding claim 13, wherein
power semiconductors are mounted on the first substrate (3) and the second substrate (5) is provided as an auxiliary connection for providing an auxiliary contact of the power semiconductor module.
